# EUROPEAN PATENT APPLICATION

(11) **EP 3 142 259 A1**
(43) Date of publication of application: **15.03.2017**
(21) Application number: 15184979.1
(22) Date of filing: 14.09.2015
(51) Int. Cl.: H04B 1/16, H03M 3/00

(54) **METHOD AND APPARATUS FOR RECEIVING SIGNALS**

(71) Applicant: Nokia Technologies Oy, 02610 Espoo (FI)
(72) Inventor: ÖSTMAN, Kim, 00530 Helsinki (FI)
(74) Representative: Nokia Corporation

(57) **Abstract**

There are disclosed various methods and apparatuses for receiving a radio frequency a signal. In some embodiments the method a signal is provided to an input of an amplifying element. An amplified signal is formed on the basis of the input signal by the amplifying element. The amplified signal is integrated by an integrating element to form an integrated signal. A feedback signal is formed on the basis of the integrated signal, wherein the feedback signal is provided to the integrating element. In some embodiments the apparatus comprises means for implementing the method.

## Description

### TECHNICAL FIELD

The present invention relates to a method for receiving radio frequency signals and an apparatus for receiving radio frequency signals.

### BACKGROUND

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

In some apparatuses a low-noise amplifier (LNA) may be used to amplify signals so that noise possibly contributed by the amplifier is as weak as possible. These kinds of amplifiers may be used, for example, in radio receivers in a so called radio frequency (RF) front end. The low noise amplifier is intended to amplify possibly quite weak signals received by an antenna before the received signals are coupled to a mixer for converting the radio frequency signals to intermediate frequency (IF) signals or to baseband (BB) signals.

Receivers implemented on semiconductor circuits such as complementary metal oxide silicon circuits (CMOS) may operate with differential signaling. While differential signaling may consume more power and circuit area compared to single-ended solutions, the differential signaling may enable doubled signal swing and better noise immunity. However, differential low noise amplifiers may need two high-frequency input/output (I/O) pads on the integrated circuit instead of one. Especially multi-band/multi-mode receivers may use several parallel low noise amplifiers wherein at least some circuit area may be saved if a single-ended input could be utilized by the low noise amplifier. This may be achieved by performing single-ended to differential (i.e., unbalanced to balanced) conversion on-chip in the low noise amplifier structure.

### SUMMARY

Various embodiments provide a method and apparatus for receiving radio frequency signals and an apparatus for receiving radio frequency signals.

Various aspects of examples of the invention are provided in the detailed description.

According to a first aspect, there is provided a method comprising:
providing a signal to an input of an amplifying element;
forming an amplified signal on the basis of the input signal by the amplifying element;
integrating the amplified signal to form an integrated signal by an integrating element;
providing the feedback signal to the integrating element;
quantizing the output of the integrating element into a digital output signal; and
forming a feedback signal on the basis of the quantized signal.

According to a second aspect, there is provided an apparatus comprising:
an amplifying element comprising an input for inputting a signal and for forming an amplified signal on the basis of the input signal;
an integrating element for integrating the amplified signal to form an integrated signal;
a quantizing element for quantizing the output of the integrating element into a digital output signal; and
a feedback element for forming a feedback signal on the basis of the quantized signal;
wherein the integrating element is further adapted to use the feedback signal in forming the integrated signal.

According to a third aspect, there is provided an apparatus comprising:
means for providing a signal to an input of an amplifying element;
means for forming an amplified signal on the basis of the input signal by the amplifying element;
means for integrating the amplified signal to form an integrated signal by an integrating element;
means for quantizing the output of the integrating element into a digital output signal;
means for forming a feedback signal on the basis of the quantized signal; and
means for providing the feedback signal to the integrating element.

### BRIEF DESCRIPTION OF THE DRAWINGS

For a more complete understanding of example embodiments of the present invention, reference is now made to the following descriptions taken in connection with the accompanying drawings in which:
Figure 1 shows a simplified block diagram of a device according to an example embodiment;
Figure 2a illustrates as a simplified circuit diagram the structure of a part of a receiver in which a voltage-mode direct delta-sigma receiver with an active loop filter is utilized, in accordance with an embodiment;
Figure 2b illustrates as a simplified diagram an example of the structure of a part of a receiver in which a current-mode direct delta-sigma receiver with an active loop filter is utilized, in accordance with an embodiment;
Figure 3a shows a signal transfer function of a receiver around a local oscillator frequency for different amounts of feedback to a post-mixer node in a voltage-mode direct delta-sigma receiver, in accordance with an embodiment;
Figure 3b shows a signal transfer function of a receiver around the local oscillator frequency for different amounts of negative conductance at the output of a low-noise amplifier in a voltage-mode direct delta-sigma receiver, in accordance with another embodiment;
Figure 4a demonstrates gain response at the output of the low-noise amplifier for different amounts of feedback to a post-mixer node in a voltage-mode direct delta-sigma receiver, in accordance with an embodiment;
Figure 4b shows that the negative conductance circuit may increase the low-noise amplifier gain around f_{LO} in a voltage-mode direct delta-sigma receiver, in accordance with an embodiment;
Figures 5a and 5b illustrate a quantization noise transfer function of a voltage-mode direct delta-sigma receiver, in accordance with an embodiment;
Figure 6 illustrates the receiver noise transfer function as a function of the inductance ratio of the secondary windings and the primary winding at the low-noise amplifier output in a voltage-mode direct delta-sigma receiver, in accordance with an embodiment;
Figure 7a shows the signal transfer function of the receiver around f_{LO}, for different magnitudes of delta-sigma feedback to the first integrator stage in a current-mode direct delta-sigma receiver, in accordance with an embodiment;
Figure 7b shows the signal transfer function gain as the function of the negative conductance at the output of the low-noise transconductance amplifier in a current-mode direct delta-sigma receiver, in accordance with an embodiment;
Figure 8a shows the signal transfer function gain of the first integrator stage in closed-loop conditions in a current-mode direct delta-sigma receiver, in accordance with an embodiment;
Figure 8b shows the signal transfer function gain of the first integrator stage as a function of the negative conductance at the output of the amplifier in a current-mode direct delta-sigma receiver, in accordance with an embodiment;
Figure 9a shows the noise transfer function of the simulation of the receiver of Figure 2b for different magnitudes of the delta-sigma feedback to the first integrator, in accordance with an embodiment;
Figure 9b shows the noise transfer function of the simulation of the receiver of Figure 2b as a function of the negative conductance at the output of the low-noise transconductance amplifier, in accordance with an embodiment;
Figure 10 shows the receiver signal transfer function around f_{LO} for different inductance ratios of the secondary windings and the primary winding at the low-noise transconductance amplifier output in a current-mode direct delta-sigma receiver, in accordance with an embodiment;
Figure 11a shows the voltage gain to the output of the low-noise transconductance amplifier for different inductance ratios of the secondary windings and the primary winding in a current-mode direct delta-sigma receiver, in accordance with an embodiment;
Figure 11b shows the output current of the low-noise transconductance amplifier for different inductance ratios of the secondary windings and the primary winding in a current-mode direct delta-sigma receiver, in accordance with an embodiment;
Figure 12 demonstrates how transformer design may be used to boost the noise shaping capability of the current-mode direct delta-sigma receiver, in accordance with an embodiment;
Figure 13 shows a block diagram of an apparatus according to an example embodiment;
Figure 14 shows an apparatus according to an example embodiment;
Figure 15 shows an example of an arrangement for wireless communication comprising a plurality of apparatuses, networks and network elements.

### DETAILED DESCRIPTON OF SOME EXAMPLE EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

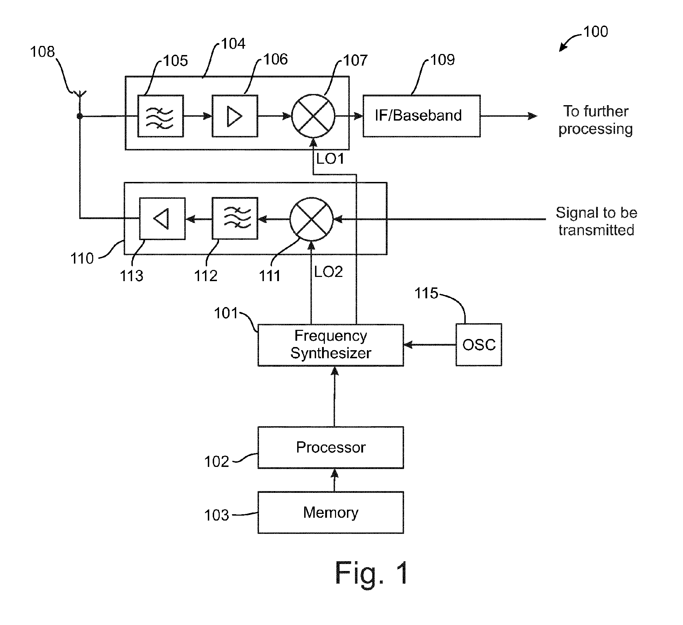

Figure 1 depicts an example of a part of a device 100, which may be, for example, a mobile device such as a mobile phone, but may also be another device comprising an amplifier 106. The device 100 may be constructed to include the frequency synthesizer 101 for generating one or more oscillator signals. The device may comprise one or more data processors 102 for controlling the operations of the device, in accordance with an embodiment. The data processor 102 operates in accordance with program instructions stored in at least one storage medium, such as at least one memory 103. The data processor 102 may control the frequency synthesizer 101 for setting the output frequency/frequencies of the frequency synthesizer 101. These output frequencies form one or more local oscillator signals that may be applied simultaneously to an RF receiver circuitry 104. The RF receiver circuitry 104 may include one or multiple instances of filters 105, amplifiers 106 and mixers 107. The RF receiver circuitry 104 may be configured to be connected with at least one, and possibly several antennas 108, and may operate to simultaneously receive and down-convert multiple reception channels in multiple frequency bands. The RF receiver circuitry 104 may be implemented e.g. as a single direct conversion receiver, as a plurality of direct conversion receivers, as a single superheterodyne-type receiver or as a plurality of superheterodyne-type receivers. In either case the down-converted signals from multiple reception channels are provided to at least one baseband circuitry block 109 to demodulate and decode received signaling and other data.

The device of Figure 1 also comprises an RF transmitter 110 for transmitting radio frequency signals. The transmitter 110 may comprise one or more mixers 111 adapted to receive signals to be transmitted and a local oscillator signal LO2. The mixing result may be provided to a band pass filter 112 to filter out mixing results which are out of the transmission band, and a power amplifier 113 to amplify the RF signals before passing them to one or more antennas 108. The one or more antennas 108 may be the same one or more antennas than the RF receiver circuitry 104 uses or different antenna(s).

The RF receiver circuitry 104, the RF transmitter 110 and/or the baseband circuitry 109 may be embodied as an integrated circuit. In some embodiments the RF receiver circuitry 104, the RF transmitter 110 and the baseband circuitry 109 or parts of them may be embodied in the same integrated circuit, and in some other embodiments they may be embodied in different integrated circuits. In some embodiments all of the circuitry shown in Figure 1, including the data processor 102 and possibly also the memory 103, may be embodied in one integrated circuit module or package.

In some embodiments all or some of the functionality of the frequency synthesizer 101 may be embodied by the data processor 102 or by another data processor, such as a high speed digital signal processor operating under control of a stored program.

In communication applications, delta-sigma modulators (DSM) may be used, for example, in baseband analog-to-digital (A/D) conversion, frequency synthesis, and audio signal digital-to-analog (D/A) conversion. It may also be possible to implement radio frequency (RF) sampling receivers based on delta-sigma modulator structures. These may include bandpass sampling, passive direct-conversion sampling, and active direct-conversion sampling. Some bandpass sampling receivers may have limited tunability and relatively high power consumption due to a high operational amplifier gain bandwidth, whereas mostly passive circuits may provide a high degree of linearity but the noise performance may not be as good as structures utilizing active direct-conversion sampling.

A direct delta-sigma receiver (DDSR) may simultaneously provide good enough tunability, linearity, noise, and power consumption. This may reduce the total number of receiver stages and may involve the radio frequency parts of the receiver in A/D conversion. In accordance with an example embodiment, the direct delta-sigma receiver may approximate a cascade of integrators in feedback (CIFB) type delta-sigma modulator. Direct delta-sigma receivers may operate in voltage-mode or in current-mode. Voltage-mode direct delta-sigma receivers may simultaneously provide acceptable linearity and noise figure. However, the voltage-mode low noise amplifier output interface with limited output impedance may degrade its noise shaping capability. On the other hand, current-mode direct delta-sigma receivers with mostly passive loop filters may exhibit good linearity at the expense of higher noise figure.

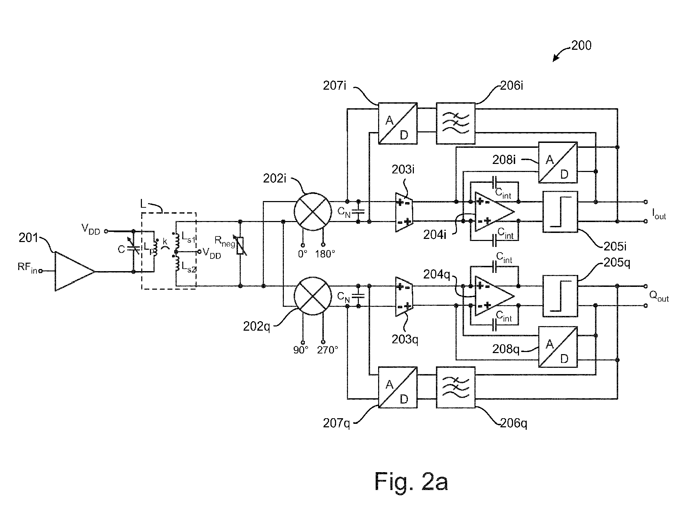

Figure 2a illustrates as a block diagram an example of a part of a receiver in which a voltage-mode direct delta-sigma receiver 200 with an active loop filter is utilized, in accordance with an embodiment. The direct delta-sigma receiver may not require up-conversion of the D/A-converted feedback to a first stage for subsequent RF processing. In accordance with an embodiment, the receiver does not require frequency translation of the delta-sigma feedback, but it still may involve the first RF stage in the A/D conversion process.

The low-noise amplifier 201 operates in voltage-mode to retain the noise benefits, and retains N-path filtering at its output for enhanced out-of-band linearity.

In accordance with an embodiment, the voltage-mode down-conversion mixing interface may be designed to provide single-ended to differential conversion. This may be done by using a transformer L at the low-noise amplifier load, where the properties of the transformer may be designed so as to obtain improved quantization noise shaping.

The direct delta-sigma receiver 200 of Figure 2a forms a frequency-translating delta-sigma modulator with a cascade of integrators in feedback (CIFB) structure, using an active loop filter.

The example direct delta-sigma receiver 200 consists of two stages, but this can be reduced to one or increased to for example three or four. Increasing the number of stages may provide a more selective signal transfer function (STF) for the input signal and a more effective quantization noise transfer function (NTF), at the cost of increased power consumption and circuit complexity. The number of stages may not affect the presented features.

In Figure 2a the integrator stages for both I-branch and Q-branch are depicted. Both branches may include similar elements starting from mixers 202i, 202q. The low-noise amplifier 201 and the output load of the low-noise amplifier 201 may be common to both branches.

In the first integrator stage, the input signal at RF_{IN} is fed to an input-matched low-noise transconductance amplifier 201 (LNTA), which may, for example, be a common-source metal oxide semiconductor (MOS) device. To complete the low noise amplifier structure, the output current from the amplifier 201 is driven into a load consisting of a tunable capacitor C and a primary winding Lₚ of the transformer L. The transformer L performs single-ended to differential conversion for the desired signal, such that a differential version may appear over the secondary windings Lₛ₁ and Lₛ₂. A negative conductance circuit R_{neg} may increase the effective output impedance of the amplifier 201. The secondary windings Lₛ₁ and Lₛ₂ may be made larger than the primary winding Lₚ to further increase the effective output impedance.

Increasing the transformer ratio Lₛ₁/Lₚ may provide better N-path filtering and higher effective output impedance of the low-noise amplifier 201. This may also lead to improved quantization noise shaping by the first integrator stage.

The amplifier 201 is followed by passive voltage-mode I/Q mixers 202i, 202q with, for example, 25 % local oscillator (LO) duty cycle that downconvert the amplifier output signal onto capacitors C_{N}. These capacitors C_{N} function as integration capacitors for the forward signal in the delta-sigma modulator. Furthermore, the mixer 202i, 202q and capacitors C_{N} together form a four-phase N-path filter that provides a bandpass response at the amplifier output and a lowpass response over the capacitors C_{N}.

The phase of the local oscillator signals which are input to the mixer 202i of the I-branch may be opposite phase signals (e.g. 0° and 180°) and the phase of the local oscillator signals which are input to the mixer 202q of the Q-branch may be opposite phase signals but having a phase difference of 90° with reference to the I-branch (e.g. 90° and 270°).

The output signal I_{OUT}, Q_{OUT} may be low-pass filtered by low-pass filters 206i, 206q to, for example, attenuate sampling images and then converted to analog form by digital-to-analog converters 207i, 207q. The resulting feedback signal may be integrated by the same capacitors C_{N}, thus completing the first integrator stage of the delta-sigma modulator.

The second integrator stage may operate completely on baseband. A transconductance stage 203i, 203q (Gₘ₂) converts the superpositioned output voltage of the first stage, in other words the voltage of the capacitor C_{N}, into a current that is fed to an operational amplifier 204i, 204q. The operational amplifiers 204i, 204q may be Miller-connected. The operational amplifiers 204i, 204q may also be provided with a feedback signal which has been derived from an output signal I_{OUT}, Q_{OUT} by converting the output signal I_{OUT}, Q_{OUT} into analog form by the digital-to-analog converters 208i, 208q. This may be implemented, for example, so that an output of the digital-to-analog converter 208i, 208q is coupled with the output of the mixer 2021, 202q. The capacitors Cᵢₙₜ integrate the forward current from the transconductance stage 203i, 203q and superposition it with the digital-to-analog converted feedback signal from the output I_{OUT}, Q_{OUT}. The output of the second stage, in other words, the outputs of the operational amplifiers 204i, 204q, may be quantized into a digital I/Q output signal by quantizers 205i, 205q.

In accordance with an embodiment, the direct delta-sigma receiver 200 could also be implemented without using the transconductance stage 203i, 203q, the operational amplifiers 204i, 204q and the digital-to-analog converters 208i, 208q. Hence, the output signal I_{OUT}, Q_{OUT} could be formed by performing the quantization at the capacitors C_{N}. This might provide first-degree (20 dB/decade) noise shaping below a corner frequency of the loop filter, until a non-ideal real noise transfer function zero below which the stage no longer shapes noise.

The use of the transformer L at the low-noise amplifier output may save one input/output (I/O) pin, may improve blocker toleration and may improve the quantization noise shaping performance of the first stage.

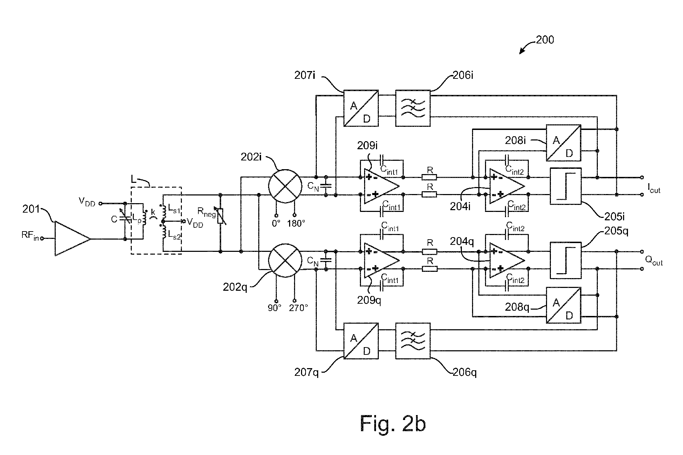

Figure 2b illustrates another example embodiment of the direct delta-sigma receiver 200. In this example the receiver is a current-mode direct delta-sigma receiver based on an active loop filter.

The current-mode operation may increase linearity as compared to voltage-mode implementations, while the use of an active loop filter simultaneously may provide noise figure improvement over the more passive implementations. Moreover, current-mode operation may reduce the quantization noise transfer function impairment that may be exhibited in voltage-mode direct delta-sigma receivers with an N-path filtering interface at the low-noise amplifier output. This may be caused by the Miller effect operating on the related integration capacitor and pushing the non-ideal real noise transfer function zero of the first stage to very low frequencies.

The example diagram of Figure 2b contains two integrator stages, but this can be reduced to one or increased to for example three or four. A greater number of stages may lead to greater selectivity (in the signal transfer function, STF) and stronger quantization noise shaping (in the noise transfer function, NTF), but may also increase the circuit complexity and complicate stability considerations.

The first stage is in essence a frequency-translating operational amplifier RC integrator, where the voltage-to-current conversion by the resistance R is done by the low-noise transconductance amplifier 209i, 209q (LNTA, for example a common-source MOS device). The input signal at RF_{IN} is fed to the low-noise amplifier 201 and the output current of the low-noise amplifier 201 is driven into a load consisting of a tunable capacitor C and the primary winding Lₚ of the transformer L. The transformer L performs single-ended to differential conversion for the desired signal current, such that a differential version appears in the secondary windings Lₛ₁ and Lₛ₂.

The negative conductance circuit R_{neg} may increase the effective output impedance of the low-noise amplifier 201. It may also be used to compensate the effective output impedance drop that may take place as the capacitor C is tuned to center the low-noise amplifier response at a lower local oscillator frequency f_{LO}. The secondary windings Lₛ₁ and Lₛ₂ can be made larger than the primary winding Lₚ to further increase the effective output impedance and improve linearity, although doing so may reduce the amount of signal current flowing to the passive mixer and thus may increase the noise figure.

The low-noise amplifier 201 is followed by passive current-mode I/Q mixers 202i, 202q with, for example, 25-% local oscillator duty cycle that downconvert the low-noise amplifier output signal current and feed it to the operational amplifiers 209i, 209q, which may be implemented as Miller-connected operational amplifiers. The low-noise amplifier output signal is integrated onto the capacitors Cᵢₙₜ₁. The operational amplifiers 209i, 209q may also be provided with a first feedback signal which has been derived from the output signal I_{OUT}, Q_{OUT} by low-pass filtering by low-pass filters 206i, 206q to, for example, attenuate sampling images and by then converting the low-pass filtered output signal I_{OUT}, Q_{OUT} into analog form by the digital-to-analog converters 207i, 207q. The resulting feedback signal is integrated by the same capacitors Cᵢₙₜ₁, thus completing the first integrator stage of the direct delta-sigma receiver 200.

The noise shaping capability of the first stage may be tied to the effective output impedance of the low-noise amplifier 201 and to the integration capacitance Cᵢₙₜ₁. The higher the impedance and the capacitance, the lower the frequency of the related non-ideal real noise transfer zero and thus the better the low-frequency noise shaping capability. In addition to the negative conductance R_{neg}, the noise transfer function zero frequency may be lowered related to the first stage by two other means: first, the low-noise amplifier output transformer L may be designed such that the effective low-noise amplifier output impedance appears higher. Second, the Miller effect may operate on Cᵢₙₜ₁ such that it appears as a much bigger capacitance (e.g. 10-100x) than, for example, the capacitors C_{N} in the voltage-mode solution of Figure 2a.

The second integrator stage of the receiver of Figure 2b may operate completely on baseband. The resistors R convert the superpositioned output voltage of the first stage into a current that is fed to the Miller-connected operational amplifiers 204i, 204q. The capacitors Cᵢₙₜ₂ integrate this forward current and superposition it with the D/A-converted feedback signal from the output. The output of the second stage is quantized into a digital I/Q output signal.

In accordance with an embodiment, the direct delta-sigma receiver 200 could also be implemented without using the operational amplifiers 204i, 204q and the digital-to-analog converters 208i, 208q. Hence, the output signal I_{OUT}, Q_{OUT} could be formed by performing the quantization at the output of the operational amplifiers 209i, 209q. This might provide first-degree (20 dB/decade) noise shaping below the corner frequency of the loop filter, until the non-ideal real noise transfer function zero below which the stage no longer shapes noise.

In accordance with an embodiment, the operation of the receiver 200 may be selectable so that it may operate in voltage-mode or in current-mode as desired. This may be performed in such a way that there are integrator stages for both the voltage-mode and current-mode. The integrator stages for the voltage-mode may be as presented in the Figure 2a and the integrator stages for the current-mode may be as presented in the Figure 2b. Hence, when the voltage-mode is selected, the transconductance stages 203i, 203q may be selected, wherein they cause a relatively high impedance level in the base-band side of the mixers 202i, 202q, which also interacts with the output stage of the low-noise amplifier 201 so that the output stage is loaded with the high impedance. This means that also the low-noise amplifier 201 actually operates in voltage-mode. On the other hand, when the current-mode is selected, the Miller-connected operational amplifier stages 209i, 209q may be selected, wherein they cause a relatively low impedance level in the base-band side of the mixers 202i, 202q, which also interacts with the output stage of the low-noise amplifier 201 so that the output stage is loaded with the low impedance. This means that also the low-noise amplifier 201 actually operates in current-mode. The voltage-mode operation or the current-mode operation may be selected as desired. For example, the signal power level of the received RX signal and/or possible occurrence of blocking signals may be used as criteria to determine whether the voltage-mode operation or the current-mode operation will be selected.

In voltage-mode the gain of the low-noise amplifier 201 may be higher than in current-mode, wherein the noise figure may be smaller, whereas in current-mode the signal swing at the output stage of the low-noise amplifier 201 may be smaller which may improve the linearity.

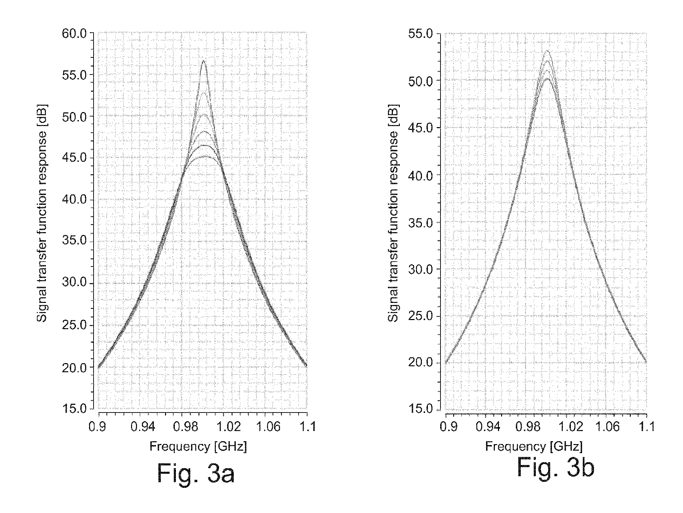

Figures 3a to 6 show some simulation results of the voltage-mode receiver 200 of Figure 2a, and Figures 7a to 11 show some simulation results of the current-mode receiver 200 of Figure 2b. The receiver 200 have been simulated with local oscillator frequency f_{LO} = 1 GHz using a continuous-time approximation. Figure 3a shows the signal transfer function of the voltage-mode receiver 200 around the local oscillator frequency f_{LO} for different amounts of feedback to the post-mixer node, and Figure 3b shows the signal transfer function for different amounts of negative conductance at the output of the amplifier 201. In practice, the strength of the feedback may be varied by changing the transconductance of the circuits that realize the current-mode D/A converter 207i, 207q. Figure 3a shows that the feedback may be used to set the signal transfer function gain close to f_{LO} and to adjust the signal transfer function bandwidth. In Figure 3b, the negative conductance circuit R_{neg} increases the signal transfer function gain at f_{LO}, thus leading to greater relative blocker filtering and lower signal transfer function bandwidth (if it is not compensated by stronger D/A-converted feedback).

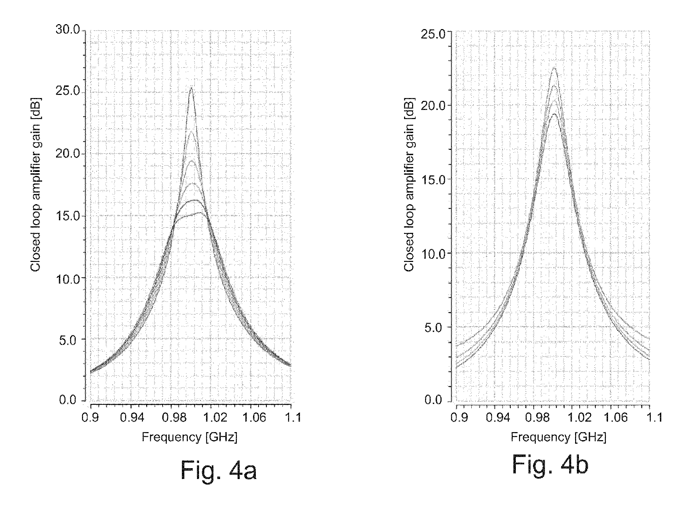

Figure 4a demonstrates the gain response at the output of the amplifier 201 in the voltage-mode receiver. The effect of the delta-sigma feedback may suppress the signal transfer function gain. This may result in increased receiver noise figure. Figure 4b shows that the negative conductance circuit may increase the amplifier gain around f_{LO}. The gain further away from f_{LO} may increase less, which may translate to improved relative blocker filtering.

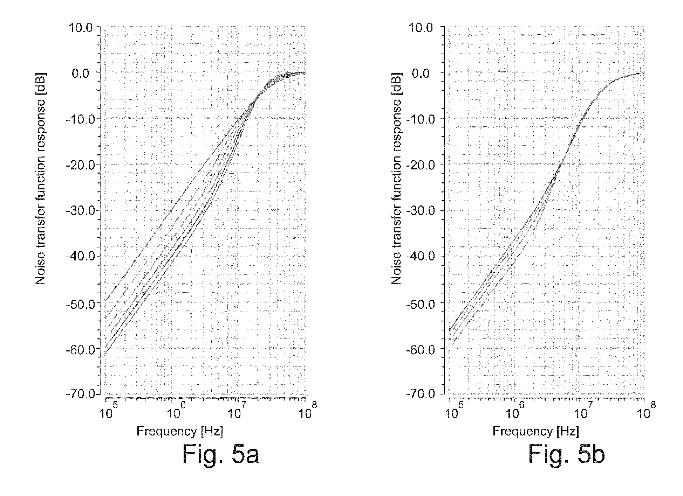

The quantization noise transfer function is illustrated in Figures 5a and 5b for the voltage-mode receiver. When the feedback to the output of the amplifier 201 output is not active (topmost curve), the noise transfer function of the two-stage receiver of Figure 2a is only of the first order, i.e., it has a slope of 20 dB/decade based on the second stage. Activating and increasing the feedback may involve the first stage in noise shaping, and thus the slope may improve to 40 dB/decade. When going downward in frequency, the finite output impedance of the amplifier in the first stage eventually may cause the operation to become only of first order (20 dB/decade) again. This is explained by the non-ideal real noise transfer function zero related to the first stage being not at f = 0 Hz (as for an ideal stage), but instead in the MHz-range.

Several methods may be used to push this noise transfer function zero downwards and thus to improve the low-frequency noise shaping. An example method is to use the negative conductance circuit referred to above. As shown on the right in Figure 5b, increasing the amount of negative conductance lowers the frequency where operation shifts from the second order to the first order.

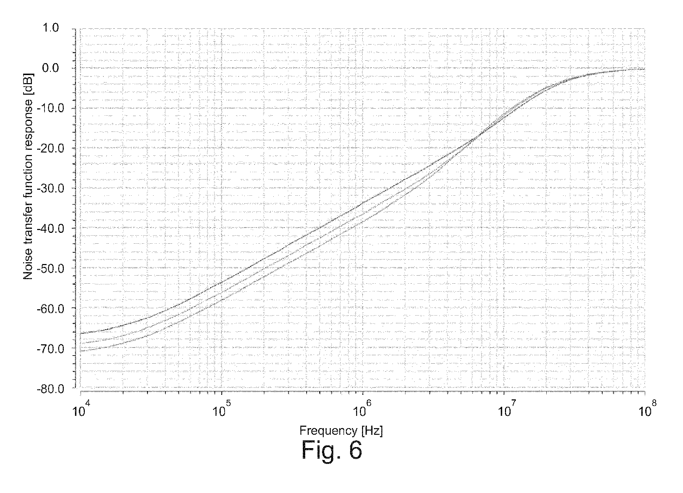

In addition to the transformer L providing single-ended to differential conversion, a high inductance ratio Lₛ₁/Lₚ may be used to obtain not only improved N-path blocker filtering, but also to improve the quantization noise shaping. As shown in Figure 6 for the voltage-mode receiver, where Lₛ₁/Lₚ = 1, 2, and 3, second-order noise transfer function behavior may pushed to even lower frequencies by increasing the inductance ratio Lₛ₁/Lₚ of the secondary windings.

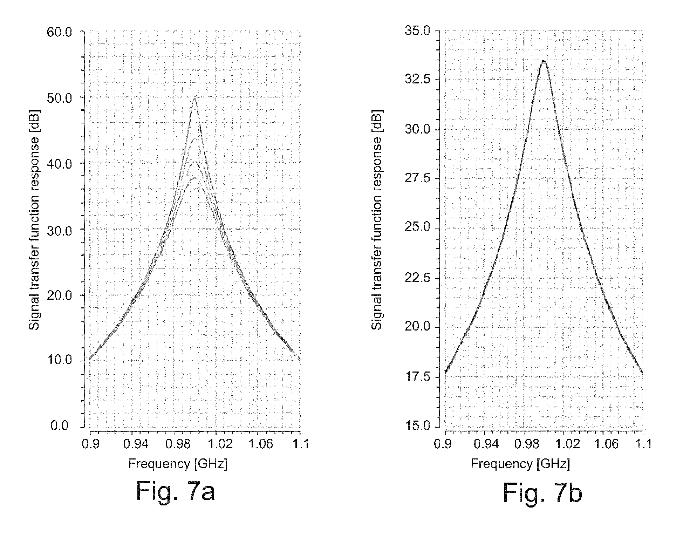

Figure 7a shows the signal transfer function of the current-mode receiver 200 around f_{LO}, for different magnitudes of delta-sigma feedback to the first integrator stage. The feedback may be used to adjust the signal transfer function in-band gain around f_{LO} and to adjust the signal transfer function bandwidth. Figure 7b shows the signal transfer function gain as the negative conductance generated by R_{neg} at the output of the low-noise transconductance amplifier 201 is swept. The signal transfer function gain may not be affected because the signal at the output of the low-noise transconductance amplifier 201 is in current-mode. The purpose of the negative conductance R_{neg} is to improve the noise shaping in addition to providing improved current-mode operation and thus better linearity.

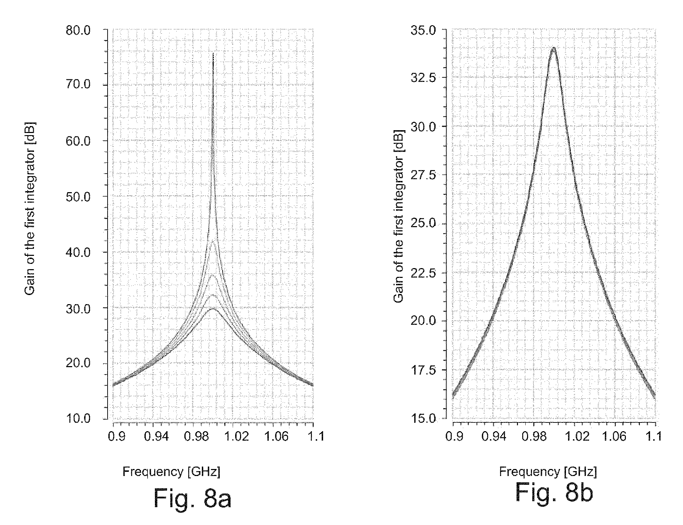

Figures 8a and 8b show the signal transfer function gain of the first integrator stage (sensed at baseband, at the output of the first operational amplifier 209i, 209q in Fig. 2b) in closed-loop conditions (Figure 8a), for different magnitudes of delta-sigma feedback from the receiver output, for the current-mode receiver. Similar to the signal transfer function of the complete receiver, the delta-sigma feedback may adjust both the signal transfer function gain and bandwidth of the first stage. Figure 8b shows the signal transfer function response of the first integrator stage when the negative conductance R_{neg} is swept. Similar to the full receiver, the signal transfer function may exhibit minimal differences due to current-mode operation.

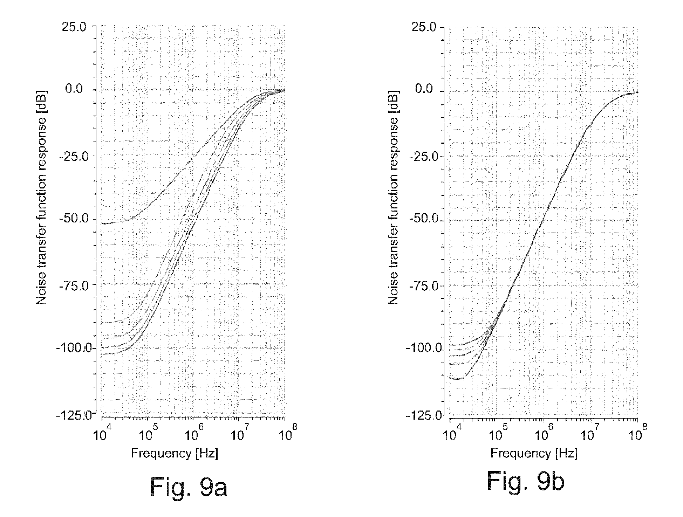

The noise transfer function of the simulation of the current-mode receiver 200 of Figure 2b is plotted in Figures 9a and 9b for different magnitudes of the delta-sigma feedback (Figure 9a) and the negative conductance R_{neg} (Figure 9b). When the delta-sigma feedback to the first stage is off (uppermost curve in Figure 9a), the receiver may exhibit first-order noise shaping of 20 dB/decade below the corner frequency of the loop filter, all the way to around 100 kHz where the imperfections of the second integrator may limit the noise shaping.

The first integrator stage including the low-noise transconductance amplifier 201 is included in quantization noise shaping by activating the delta-sigma feedback. As shown on Figure 9a, the noise transfer function slope increases to 40 dB/decade, until the imperfections of both integrator stages cause a floor to be reached. As discussed previously, changes in the delta-sigma feedback may also change the bandwidth of the receiver if not compensated otherwise, and thus Figure 9a also shows a change in the corner frequency.

Figure 9b shows that the negative conductance circuit may be used to boost the noise shaping performance of the first stage. In essence, it may move the non-ideal real noise transfer function zero to an even lower frequency and thus may reduce the imperfections of the first stage. As a result, the quantization noise may be shaped at even lower frequencies until the floor is reached.

In addition to providing single-ended to differential conversion, the inclusion of the transformer L may provide new degrees of performance enhancement. The secondary/primary inductance ratio Lₛ₁/Lₚ of the transformer windings may be used to trade off linearity with noise figure on the one hand, and to obtain stronger first-stage quantization noise shaping on the other.

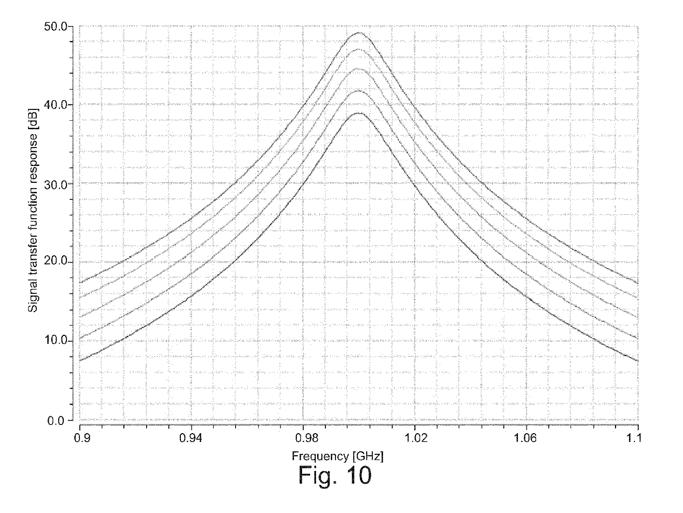

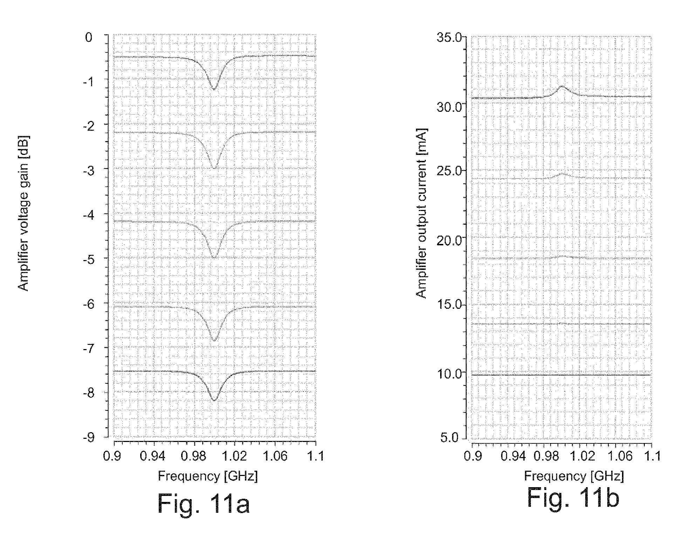

Figure 10 shows the current-mode receiver signal transfer function around f_{LO} for Lₛ₁/Lₚ values of ¼, ½, 1, 2, and 4. A higher value may lead to greater effective impedance of the output of the low-noise transconductance amplifier 201 and thus improved current-mode operation and greater linearity. However, it may reduce the amount of signal current induced into the secondary windings, wherein the signal transfer function gain may consequently be reduced. Figures 11a and 11b illustrate the related operation further. In Figure 11a, the voltage gain to the output of the low-noise transconductance amplifier 201 is reduced for a greater inductance ratio, because the load impedance (R_{neg}, passive mixer switches, and the near-virtual-ground input of the baseband operational amplifier) is reflected to the output of the low-noise transconductance amplifier 201 as an even lower impedance. Receiver linearity may be improved by the consequent lower voltage swing. Figure 11b illustrates the tradeoff through lower output current of the low-noise transconductance amplifier 201, and consequently a lower signal transfer function gain and higher receiver noise figure.

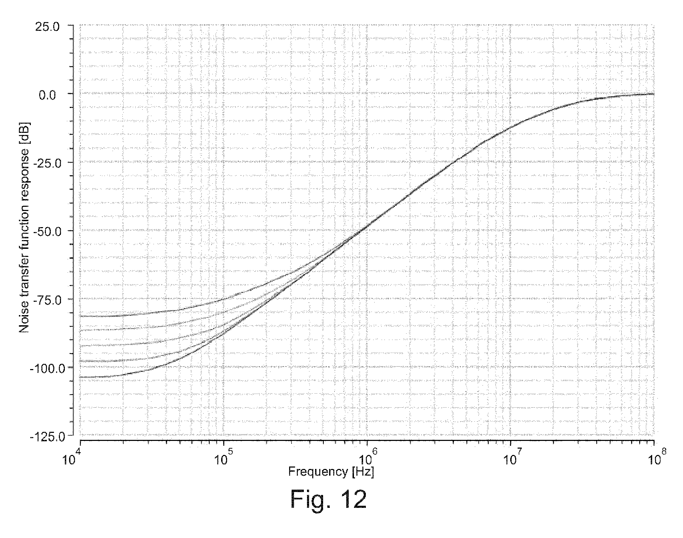

Figure 12 demonstrates how transformer design may be used to boost the noise shaping capability of the current-mode direct delta-sigma receiver 200. A higher inductance ratio may lead to a higher effective output impedance of the low-noise transconductance amplifier 201, which in turn may reduce the frequency of the non-ideal real noise transfer function zero related to the first integrator stage. Figure 12 shows that a higher Lₛ₁/Lₚ ratio may push the noise transfer function zero significantly downward, and thus the 40 dB/decade slope of the two-stage example receiver may be pushed to significantly lower frequencies. As discussed above, a higher turns ratio is also related to lower output current of the low-noise transconductance amplifier 201.

As a conclusion, the low-noise transconductance amplifier transformer L in the current-mode receiver may be used to provide noise shaping performance improvement inter alia by moving the non-ideal real noise transfer function zero of the first integrator to lower frequencies through the Miller effect. The transformer L may improve the quantization noise shaping properties of the direct delta-sigma receiver 200 even further, by moving the noise transfer function zero of the first integrator to lower frequencies. An active loop filter may be utilized for improved noise figure and improved noise shaping. The use of the negative conductance circuit may increase the effective low-noise amplifier output impedance. In accordance with an embodiment, only one passive I/Q mixer may be used instead of two, i.e., no up-conversion of the delta-sigma feedback needs to be performed. Furthermore, if a single-ended input is used, the number of I/O pins for practical implementations on an integrated circuit may be one less than if a differential input to the low-noise operational amplifier 201 were used.

The amplifier structure presented above may provide that the input RF stage (the low-noise amplifier 201) is involved in quantization noise shaping. Furthermore, the transformer L introduced into the direct delta-sigma receiver 200 may increase the effective output impedance of the low-noise amplifier 201. This feature may improve both the N-path filtering and the quantization noise shaping properties of the voltage-mode direct delta-sigma receiver 200. Still further, performing signal down-conversion at the output may remove the need for a post-low-noise amplifier RF stage. This stage may instead be replaced by a baseband amplifier that may be easier to control and program. The direct delta-sigma receiver 200 may also perform single-ended to differential conversion through transformer action, thus saving one high-frequency IC I/O pad.

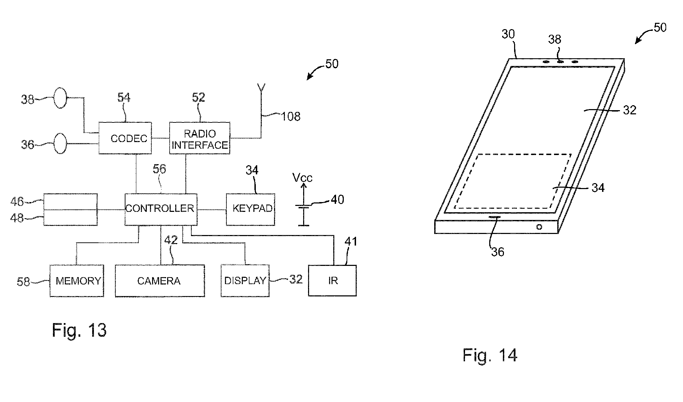

The following describes in further detail suitable apparatus and possible mechanisms for implementing the embodiments of the invention. In this regard reference is first made to Figure 13 which shows a schematic block diagram of an exemplary apparatus or electronic device 50 depicted in Figure 14, which may incorporate a transmitter according to an embodiment of the invention.

The electronic device 50 may for example be a mobile terminal or user equipment of a wireless communication system. However, it would be appreciated that embodiments of the invention may be implemented within any electronic device or apparatus which may require transmission of radio frequency signals.

The apparatus 50 may comprise a housing 30 for incorporating and protecting the device. The apparatus 50 further may comprise a display 32 in the form of a liquid crystal display. In other embodiments of the invention the display may be any suitable display technology suitable to display an image or video. The apparatus 50 may further comprise a keypad 34. In other embodiments of the invention any suitable data or user interface mechanism may be employed. For example the user interface may be implemented as a virtual keyboard or data entry system as part of a touch-sensitive display. The apparatus may comprise a microphone 36 or any suitable audio input which may be a digital or analogue signal input. The apparatus 50 may further comprise an audio output device which in embodiments of the invention may be any one of: an earpiece 38, speaker, or an analogue audio or digital audio output connection. The apparatus 50 may also comprise a battery 40 (or in other embodiments of the invention the device may be powered by any suitable mobile energy device such as solar cell, fuel cell or clockwork generator). The term battery discussed in connection with the embodiments may also be one of these mobile energy devices. Further, the apparatus 50 may comprise a combination of different kinds of energy devices, for example a rechargeable battery and a solar cell. The apparatus may further comprise an infrared port 41 for short range line of sight communication to other devices. In other embodiments the apparatus 50 may further comprise any suitable short range communication solution such as for example a Bluetooth wireless connection or a USB/firewire wired connection.

The apparatus 50 may comprise a controller 56 or processor for controlling the apparatus 50. The controller 56 may be connected to memory 58 which in embodiments of the invention may store both data and/or may also store instructions for implementation on the controller 56. The controller 56 may further be connected to codec circuitry 54 suitable for carrying out coding and decoding of audio and/or video data or assisting in coding and decoding carried out by the controller 56.

The apparatus 50 may further comprise a card reader 48 and a smart card 46, for example a universal integrated circuit card (UICC) reader and a universal integrated circuit card for providing user information and being suitable for providing authentication information for authentication and authorization of the user at a network.

The apparatus 50 may comprise radio interface circuitry 52 connected to the controller and suitable for generating wireless communication signals for example for communication with a cellular communications network, a wireless communications system or a wireless local area network. The apparatus 50 may further comprise an antenna 108 connected to the radio interface circuitry 52 for transmitting radio frequency signals generated at the radio interface circuitry 52 to other apparatus(es) and for receiving radio frequency signals from other apparatus(es).

In some embodiments of the invention, the apparatus 50 comprises a camera 42 capable of recording or detecting imaging.

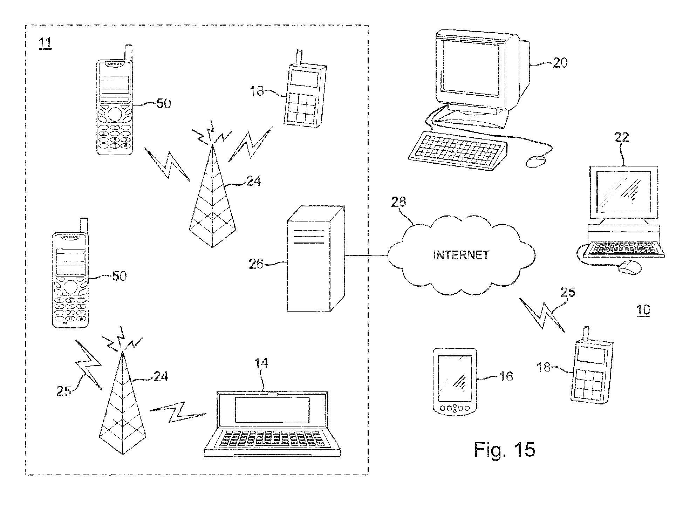

With respect to Figure 15, an example of a system within which embodiments of the present invention can be utilized is shown. The system 10 comprises multiple communication devices which can communicate through one or more networks. The system 10 may comprise any combination of wired and/or wireless networks including, but not limited to a wireless cellular telephone network (such as a global systems for mobile communications (GSM), universal mobile telecommunications system (UMTS), long term evolution (LTE) based network, code division multiple access (CDMA) network etc.), a wireless local area network (WLAN) such as defined by any of the IEEE 802.x standards, a Bluetooth personal area network, an Ethernet local area network, a token ring local area network, a wide area network, and the Internet.

For example, the system shown in Figure 15 shows a mobile telephone network 11 and a representation of the internet 28. Connectivity to the internet 28 may include, but is not limited to, long range wireless connections, short range wireless connections, and various wired connections including, but not limited to, telephone lines, cable lines, power lines, and similar communication pathways.

The example communication devices shown in the system 10 may include, but are not limited to, an electronic device or apparatus 50, a combination of a personal digital assistant (PDA) and a mobile telephone 14, a PDA 16, an integrated messaging device (IMD) 18, a desktop computer 20, a notebook computer 22, a tablet computer. The apparatus 50 may be stationary or mobile when carried by an individual who is moving. The apparatus 50 may also be located in a mode of transport including, but not limited to, a car, a truck, a taxi, a bus, a train, a boat, an airplane, a bicycle, a motorcycle or any similar suitable mode of transport.

Some or further apparatus may send and receive calls and messages and communicate with service providers through a wireless connection 25 to a base station 24. The base station 24 may be connected to a network server 26 that allows communication between the mobile telephone network 11 and the internet 28. The system may include additional communication devices and communication devices of various types.

The communication devices may communicate using various transmission technologies including, but not limited to, code division multiple access (CDMA), global systems for mobile communications (GSM), universal mobile telecommunications system (UMTS), time divisional multiple access (TDMA), frequency division multiple access (FDMA), transmission control protocol-internet protocol (TCP-IP), short messaging service (SMS), multimedia messaging service (MMS), email, instant messaging service (IMS), Bluetooth, IEEE 802.11, Long Term Evolution wireless communication technique (LTE) and any similar wireless communication technology. A communications device involved in implementing various embodiments of the present invention may communicate using various media including, but not limited to, radio, infrared, laser, cable connections, and any suitable connection. In the following some example implementations of apparatuses utilizing the present invention will be described in more detail.

Although the above examples describe embodiments of the invention operating within a wireless communication device, it would be appreciated that the invention as described above may be implemented as a part of any apparatus comprising a circuitry in which radio frequency signals are transmitted and received. Thus, for example, embodiments of the invention may be implemented in a mobile phone, in a base station, in a computer such as a desktop computer or a tablet computer comprising radio frequency communication means (e.g. wireless local area network, cellular radio, etc.).

In general, the various embodiments of the invention may be implemented in hardware or special purpose circuits or any combination thereof. While various aspects of the invention may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

In the following some examples will be provided.

According to a first example, there is provided a method comprising:
providing a signal to an input of an amplifying element;
forming an amplified signal on the basis of the input signal by the amplifying element;
integrating the amplified signal to form an integrated signal by an integrating element;
providing the feedback signal to the integrating element; and
quantizing the output of the integrating element into a digital output signal; and
forming a feedback signal on the basis of the integrated signal;.

In some embodiments the method comprises:
integrating the integrated signal to form a second integrated signal; and
forming the quantized signal on the basis of the second integrated signal.

In some embodiments the method comprises:
performing the integration of the amplified signal in a voltage-mode to obtain an integrated voltage-mode signal;
converting the integrated voltage-mode signal into a current signal; and
integrating the current signal to form the second integrated signal.

In some embodiments the method comprises:
providing a voltage-mode and current-mode operation for the integration;
selecting the integration of the amplified signal to be performed either in the voltage-mode or in the current-mode In some embodiments the method comprises:
   using a capacitance for the integration of the amplified signal; and
   using the same capacitance for integrating the feedback signal.

In some embodiments the method comprises:
converting a radio frequency signal to a base-band signal; and
performing the integration on the base-band signal.

According to a second example, there is provided an apparatus comprising:
an amplifying element comprising an input for inputting a signal and for forming an amplified signal on the basis of the input signal;
an integrating element for integrating the amplified signal to form an integrated signal;
a quantizing element for quantizing the output of the integrating element into a digital output signal; and
a feedback element for forming a feedback signal on the basis of the quantized signal;
wherein the integrating element is further adapted to use the feedback signal in forming the integrated signal.

In some embodiments the apparatus comprises:
a second integrating element for integrating the integrated signal to form a second integrated signal;
wherein the quantizing element is adapted to form the quantized signal on the basis of the second integrated signal.

In some embodiments the apparatus comprises:
the integrating element is adapted to operate in a voltage-mode to obtain an integrated voltage-mode signal;
wherein the apparatus comprises a transconductance stage adapted to convert the integrated voltage-mode signal into a current signal; and
wherein the second integrating element is adapted to integrate the current signal to form the second integrated signal.

In some embodiments of the apparatus:
the integrating element is adapted to operate in a current-mode to obtain an integrated current-mode signal;
wherein the second integrating element is adapted to integrate the current signal to form the second integrated signal.

In some embodiments of the apparatus:
the operation mode of the integrating element is adapted to be selectable among voltage-mode and current-mode.

In some embodiments the apparatus comprises:
a capacitance for the integration of the amplified signal and the feedback signal.

In some embodiments the apparatus comprises:
a mixer for converting a radio frequency signal to a base-band signal; and
performing the integration on the base-band signal.

In some embodiments the apparatus comprises:
a mixer for converting a radio frequency signal to a base-band signal, the mixer having an output; and
an output of the feedback element coupled with the output of the mixer;
wherein the apparatus is adapted to provide the base-band signal and the feedback signal to the integrating element.

In some embodiments the apparatus comprises:
an input for receiving the radio frequency signal; and
an amplifier for amplifying the radio frequency signal.

In some embodiments the apparatus comprises:
an output stage for outputting the amplified radio frequency signal; the output stage having a negative conductance.

In some embodiments the apparatus the apparatus is a part of a receiver of a wireless communication device.

According to a third example, there is provided an apparatus comprising:
means for providing a signal to an input of an amplifying element;
means for forming an amplified signal on the basis of the input signal by the amplifying element;
means for integrating the amplified signal to form an integrated signal by an integrating element;
means for forming a feedback signal on the basis of the integrated signal;
means for quantizing the output of the integrating element into a digital output signal; and
means for providing the feedback signal to the integrating element.

In some embodiments the apparatus comprises:
means for quantizing the integrated signal to form a quantized signal; and
means for forming the feedback signal from the quantized signal.

In some embodiments the apparatus comprises:
means for integrating the integrated signal to form a second integrated signal; and
means for forming the quantizing signal on the basis of the second integrated signal.

In some embodiments the apparatus comprises:
means for performing the integration of the amplified signal in a voltage-mode to obtain an integrated voltage-mode signal;
means for converting the integrated voltage-mode signal into a current signal; and
means for integrating the current signal to form the second integrated signal.

In some embodiments the apparatus comprises:
means for performing the integration of the amplified signal in a current-mode to obtain an integrated current-mode signal; and
means for integrating the current signal to form the second integrated signal.

In some embodiments the apparatus comprises:
means for providing a voltage-mode and current-mode operation for the integration;
means for selecting the integration of the amplified signal to be performed either in the voltage-mode or in the current-mode.

In some embodiments the apparatus comprises:
means for using a capacitance for the integration of the amplified signal; and
means for using the same capacitance for integrating the feedback signal.

In some embodiments the apparatus comprises:
means for converting a radio frequency signal to a base-band signal; and
means for performing the integration on the base-band signal.

## Claims

1. A method comprising:
providing a signal to an input of an amplifying element;
forming an amplified signal on the basis of the input signal by the amplifying element;
integrating the amplified signal to form an integrated signal by an integrating element;
providing the feedback signal to the integrating element; and
quantizing the output of the integrating element into a digital output signal; and
forming a feedback signal on the basis of the quantized signal.

2. The method according to claim 1, comprising:
integrating the integrated signal to form a second integrated signal; and
forming the quantized signal on the basis of the second integrated signal.

3. The method according to claim 2 comprising:
performing the integration of the amplified signal in a voltage-mode to obtain an integrated voltage-mode signal;
converting the integrated voltage-mode signal into a current signal; and
integrating the current signal to form the second integrated signal.

4. The method according to claim 2 comprising:
performing the integration of the amplified signal in a current-mode to obtain an integrated current-mode signal; and
integrating the current signal to form the second integrated signal.

5. The method according to any of the claims 1 to 4 comprising:
providing a voltage-mode and current-mode operation for the integration;
selecting the integration of the amplified signal to be performed either in the voltage-mode or in the current-mode.

6. The method according to any of the claims 1 to 5 comprising:
using a capacitance for the integration of the amplified signal; and
using the same capacitance for integrating the feedback signal.

7. The method according to any of the claims 1 to 6 comprising:
converting a radio frequency signal to a base-band signal;; and
performing the integration on the base-band signal.

8. An apparatus comprising:
an amplifying element comprising an input for inputting a signal and for forming an amplified signal on the basis of the input signal;
an integrating element for integrating the amplified signal to form an integrated signal;
a quantizing element for quantizing the output of the integrating element into a quantized signal; and
a feedback element for forming a feedback signal on the basis of the quantized signal;
wherein the integrating element is further adapted to use the feedback signal in forming the integrated signal.

9. The apparatus according to claim 8, comprising:
a second integrating element for integrating the integrated signal to form a second integrated signal;
wherein the quantizing element is adapted to form the quantized signal on the basis of the second integrated signal.

10. The apparatus according to claim 8 or 9 comprising:
the integrating element is adapted to operate in a voltage-mode to obtain an integrated voltage-mode signal;
wherein the apparatus comprises a transconductance stage adapted to convert the integrated voltage-mode signal into a current signal; and
wherein the second integrating element is adapted to integrate the current signal to form the second integrated signal.

11. The apparatus according to claim 8 or 9, wherein:
the integrating element is adapted to operate in a current-mode to obtain an integrated current-mode signal;
wherein the second integrating element is adapted to integrate the current signal to form the second integrated signal.

12. The apparatus according to any of the claims 8 to 11, wherein:
the operation mode of the integrating element is adapted to be selectable among voltage-mode and current-mode.

13. The apparatus according to any of the claims 8 to 12 comprising:
a mixer for converting a radio frequency signal to a base-band signal, the mixer having an output; and
an output of the feedback element coupled with the output of the mixer;
wherein the apparatus is adapted to provide the base-band signal and the feedback signal to the integrating element.

14. The apparatus according to claim 13, the amplifier comprising:
an output stage for outputting the amplified radio frequency signal; the output stage having a negative conductance.

15. The apparatus according to any of the claims 8 to 14, wherein the apparatus is a part of a receiver of a wireless communication device.
